# FASCICULE DE BREVET EUROPEEN

(11) **EP 3 565 111 B1**
(45) Date de publication et mention de la délivrance du brevet: **16.09.2020**
(21) Numéro de dépôt: 19172365.9
(22) Date de dépôt: 02.05.2019
(51) Int. Cl.: H02S 20/32, H02S 40/22, H01L 31/042

(54) **SYSTÈME D'ÉNERGIE SOLAIRE PHOTOVOLTAÏQUE À MIROIRS ESCAMOTABLES**
PHOTOVOLTAISCHES SYSTEM FÜR SOLAR ENERGIE MIT EINZIEHBAREN SPIEGELN
SOLAR ENERGY PHOTOVOLTAIC SYSTEM COMPRISING RETRACTABLE MIRRORS

(30) Priorité: 04.05.2018 FR 1853877
(43) Date de publication de la demande: 06.11.2019
(73) Titulaire: Commissariat à l'énergie atomique et aux énergies alternatives, 75015 Paris (FR)
(72) Inventeur: PILAT, Eric, 38054 GRENOBLE cedex 9 (FR); AL SHAKARCHI, Franck, 38054 GRENOBLE cedex 9 (FR); SAYRITUPAC VERA, José Ruben, 38054 GRENOBLE cedex 9 (FR)
(74) Mandataire: Brevalex

(56) Documents cités:
- EP-A1- 3 266 703
- CN-U- 206 388 718
- US-A1- 2017 063 295
- US-A1- 2017 133 979

## Description

### DOMAINE TECHNIQUE

La présente invention se rapporte au domaine de l'énergie solaire photovoltaïque, et en particulier à des systèmes comprenant des cellules solaires photovoltaïques bifaciales.

L'invention s'applique en particulier à des systèmes destinés à être installés au sol ou sur des toitures de bâtiments.

### ÉTAT DE LA TECHNIQUE ANTÉRIEURE

De l'art antérieur, il est connu de réaliser des systèmes comprenant des cellules solaires photovoltaïques de nature bifaciale, ces cellules étant regroupées au sein de panneaux photovoltaïques. L'intérêt de telles cellules réside dans le fait qu'elles définissent deux surfaces d'absorption opposées, par exemple en face avant une surface d'absorption directe destinée à absorber une énergie de rayonnement solaire, et, en face arrière, une surface d'absorption indirecte également destinée à absorber une énergie de rayonnement solaire.

Plusieurs réalisations ont déjà été envisagées pour l'obtention de ce type de système. Il est par exemple connu le document CN 204993212, dans lequel il est décrit des systèmes équipés de panneaux comprenant des cellules photovoltaïques bifaciales, prolongés vers le bas par des réflecteurs. Chaque réflecteur est incliné pour permettre l'irradiation de la surface arrière des cellules d'un autre système situé plus en avant. Ce type de conception présente néanmoins de nombreux inconvénients, au premier rang lesquels la nécessité de faire coopérer un système avec au moins un autre système situé en avant, afin d'illuminer sa surface arrière d'absorption indirecte. L'utilisation de ce type de système demeure ainsi cantonnée à des centrales solaires présentant une pluralité de rangées de systèmes. De plus, la distance entre chaque rangée devient un paramètre dépendant de ce besoin en irradiation de la surface arrière par les systèmes de la rangée arrière, de sorte que l'encombrement au sol de la centrale peut s'avérer non-optimisé. Il en est de même pour l'encombrement selon la direction verticale, en raison de la nécessité de prévoir des châssis suffisamment surélevés pour permettre d'implanter les réflecteurs au bas des panneaux solaires.

Ces mêmes inconvénients se retrouvent sur d'autres systèmes, comprenant deux miroirs agencés symétriquement sous les panneaux photovoltaïques, pour en illuminer la surface d'absorption indirecte. En effet, un déport vertical de ces miroirs est nécessaire afin d'autoriser l'amplitude de rotation requise pour le suivi de la trajectoire du soleil, tout au long de la journée. En cas de déport vertical trop faible des miroirs, ceux-ci sont susceptibles de limiter la course de rotation de l'unité rotative comprenant les panneaux photovoltaïques et les miroirs, en venant en interaction avec la toiture ou avec le sol sur lequel repose le système. En outre, lorsque l'unité rotative est inclinée du côté d'un premier des deux miroirs symétriques pour orienter au mieux sa surface d'absorption directe par rapport à un soleil bas dans le ciel, le second miroir se trouve alors dans une position générant une ombre préjudiciable pour le système directement consécutif dans la rangée de la centrale solaire concernée. Pour éviter cet ombrage qui est d'autant plus conséquent que le soleil est rasant, les systèmes d'une même rangée peuvent être espacés les uns des autres. Cependant, cet espacement des systèmes engendre un taux non-optimisé d'occupation du sol ou de la toiture, avec pour conséquence un potentiel énergétique perfectible en rapport avec le mètre carré foncier. Un autre example d'un système équipé de panneaux comprenant des cellules photovoltaïques et des réflecteurs est décrit dans le document US 2017/133979 A1.

### EXPOSÉ DE L'INVENTION

L'invention a donc pour but de remédier au moins partiellement aux inconvénients mentionnés ci-dessus, relatifs aux réalisations de l'art antérieur.

Pour ce faire, l'invention a tout d'abord pour objet un système d'énergie solaire photovoltaïque comportant :
- une structure de base ;
- une unité rotative ;
- une liaison de rotation entre l'unité rotative et la structure de base, la liaison de rotation définissant un axe de pivotement de l'unité rotative,
l'unité rotative comprenant :
- un ensemble de cellules solaires photovoltaïques bifaciales, définissant conjointement deux surfaces opposées destinées à absorber une énergie de rayonnement solaire ;
- un châssis de support desdites cellules, le châssis comprenant au moins un bras de déport des cellules par rapport à la structure de base, une extrémité basse du bras de déport étant raccordée à la liaison de rotation ;
- deux miroirs définissant chacun une surface de réflexion configurée pour réfléchir la lumière en direction de l'ensemble de cellules, de préférence en direction d'une surface d'absorption indirecte de cet ensemble, les deux miroirs étant disposés respectivement de part et d'autre du bras de déport.

Selon l'invention, au moins l'un des deux miroirs est mobile en présentant une première extrémité montée pivotante sur un moyen coulissant le long du bras de déport, le moyen coulissant étant déplaçable entre une position haute amenant le miroir mobile dans une configuration d'envergure maximale, et une position basse amenant le miroir mobile dans une configuration d'envergure minimale dans laquelle une seconde extrémité du miroir mobile, opposée à la première extrémité, se situe plus proche du bras de déport que dans la configuration d'envergure maximale.

Ainsi, l'invention se rapporte à un système avec au moins l'un des deux miroirs, et de préférence les deux, à caractère escamotable. En effet, en même temps que sa première extrémité se déplace vers le bas le long du bras de déport, le miroir mobile tend à se refermer avec sa seconde extrémité opposée qui se rapproche de ce même bras. Par conséquent, lorsque l'unité rotative est inclinée du côté de l'un des deux miroirs, par exemple pour orienter au mieux sa surface d'absorption directe par rapport à un soleil bas dans le ciel, le second miroir peut alors adopter la configuration d'envergure minimale ou une configuration proche de celle-ci, afin de limiter l'ombrage induit sur le système directement consécutif dans la rangée de la centrale solaire concernée.

Les systèmes d'une même rangée peuvent alors être rapprochés les uns des autres, en optimisant ainsi l'occupation du sol ou de la toiture, et en augmentant par conséquent le potentiel énergétique en rapport avec le mètre carré foncier. A titre d'exemple, il a été déterminé qu'en mettant en œuvre le principe de miroirs escamotables sur les systèmes d'une rangée de centrale solaire, le nombre de systèmes au sein de cette rangée pouvait être augmenté d'au moins 75%.

En outre, le miroir situé du côté où s'incline l'unité rotative peut également être replié pour limiter les interactions avec le sol ou la toiture. De ce fait, la longueur du bras de déport de l'unité rotative peut être diminuée, avec pour conséquence un gain en termes de masse et d'encombrement vertical, tout en autorisant le suivi du soleil tout au long de la journée.

L'invention prévoit également les caractéristiques optionnelles suivantes, prises isolément ou en combinaison.

Le châssis de support comporte également un cadre fixé sur une extrémité haute du bras de déport, et un dispositif de liaison est prévu entre chaque miroir mobile et le cadre du châssis de support, ce dispositif de liaison comprenant un organe coulissant le long du miroir mobile, ainsi qu'un organe de pivotement permettant une rotation de l'organe coulissant relativement au cadre.

De préférence, le cadre est sensiblement parallèle à l'ensemble de cellules solaires photovoltaïques bifaciales, le cadre étant interposé entre les deux miroirs et l'ensemble de cellules.

Le châssis de support comporte également une pluralité d'armatures reliant le cadre à l'ensemble de cellules solaires photovoltaïques bifaciales.

Le miroir mobile définit un angle aigu d'inclinaison de miroir avec un plan orthogonal à l'ensemble de cellules solaires photovoltaïques bifaciales, l'angle aigu d'inclinaison de miroir étant compris entre 5 et 30° dans la configuration d'envergure minimale, et compris entre 65 et 80° dans la configuration d'envergure maximale.

Les deux miroirs sont mobiles, et agencés de manière à être déplacés de façon symétrique ou dissymétrique.

Selon une possibilité, les deux miroirs mobiles sont agencés de manière à être déplacés de façon symétrique, la première extrémité de chacun d'eux étant montée pivotante sur un même moyen coulissant le long du bras de déport.

Selon une autre possibilité, les deux miroirs mobiles sont agencés de manière à être déplacés de façon dissymétrique, la première extrémité de chacun d'eux étant montée pivotante respectivement sur deux moyens distincts coulissant le long du bras de déport.

L'ensemble de cellules solaires photovoltaïques bifaciales peut être configuré pour être déplacé latéralement du côté de l'un des deux miroirs, et du côté de l'autre miroir. Dans ce cas de figure, il est par exemple prévu que le châssis de support comporte un dispositif à parallélogramme déformable conçu pour déplacer latéralement l'ensemble de cellules solaires photovoltaïques bifaciales. Alternativement, il pourrait s'agir d'un simple moyen de translation de l'ensemble de cellules, sans sortir du cadre de l'invention.

Le système comporte également au moins un premier actionneur de la liaison de rotation entre l'unité rotative et la structure de base, ainsi qu'au moins un second actionneur de miroir mobile, le/les premiers actionneurs étant distincts du/des seconds actionneurs.

Alternativement, le système comporte un actionneur commun commandant simultanément la liaison de rotation entre l'unité rotative et la structure de base, ainsi que chaque miroir mobile.

L'invention a également pour objet une centrale solaire comprenant au moins une rangée de systèmes d'énergie solaire photovoltaïque tel que celui décrit ci-dessus, les axes de pivotement des unités rotatives appartenant aux systèmes de la rangée considérée, étant parallèles entre eux.

La centrale comporte préférentiellement plusieurs rangées de systèmes d'énergie solaire photovoltaïque.

Enfin, l'invention a pour objet un procédé de commande d'une telle centrale solaire, mis en œuvre de sorte qu'au cours d'une journée, l'unité rotative des systèmes de chaque rangée est pivotée d'une position extrême de matinée dans laquelle l'unité est inclinée du côté d'un premier des deux miroirs, à une position extrême de soirée dans laquelle l'unité rotative est inclinée du côté d'un second des deux miroirs, en passant par une position médiane verticale de l'unité rotative, le procédé étant également mis en œuvre de manière à ce que pour au moins l'un des systèmes d'au moins l'une des rangées :
le premier miroir mobile est déplacé de sa configuration d'envergure minimale vers sa configuration d'ouverture maximale lorsque l'unité rotative est déplacée de la position extrême de matinée vers sa position médiane verticale, et/ou le premier miroir mobile est déplacé de sa configuration d'envergure maximale vers sa configuration d'ouverture minimale lorsque l'unité rotative est déplacée de sa position médiane verticale vers la position extrême de soirée ;
et/ou
le second miroir mobile est déplacé de sa configuration d'envergure minimale vers sa configuration d'ouverture maximale lorsque l'unité rotative est déplacée de la position extrême de matinée vers sa position médiane verticale, et/ou le second miroir mobile est déplacé de sa configuration d'envergure maximale vers sa configuration d'ouverture minimale lorsque l'unité rotative est déplacée de sa position médiane verticale vers la position extrême de soirée.

D'autres avantages et caractéristiques de l'invention apparaîtront dans la description détaillée non limitative ci-dessous.

### BRÈVE DESCRIPTION DES DESSINS

Cette description sera faite au regard des dessins annexés parmi lesquels ;
- la figure 1 représente une vue de face d'une centrale solaire, montrant l'une des rangées de systèmes chacune formée par une pluralité de systèmes selon un mode de réalisation préféré de l'invention ;
- la figure 2 est une vue en perspective de l'un des systèmes montrés sur la figure précédente ;
- la figure 3 représente une vue de face de celle de la figure précédente, schématisant le fonctionnement du système et avec son unité rotative montrée dans une position médiane verticale ;
- la figure 3a est une vue similaire à celle de la figure 3, selon une alternative de réalisation ;
- la figure 4 représente une vue de face de deux systèmes agencés de façon directement consécutive dans la rangée, ces systèmes étant montrés avec leurs unités rotatives dans une position extrême de matinée ;
- la figure 5 représente une vue analogue à la précédente, et sur laquelle les deux systèmes sont montrés avec leurs unités rotatives dans une position extrême de soirée ;
- la figure 6 représente une vue partielle de l'un des deux systèmes de la figure précédente, schématisant une fonctionnalité particulière de l'invention ;
- la figure 7 représente une vue similaire à celle de la figure 5, avec les systèmes se présentant sous la forme d'un autre mode de réalisation préféré de l'invention ; et
- la figure 8 représente une vue similaire à la précédente, avec les unités rotatives agencées dans leur position extrême de matinée.

### EXPOSÉ DÉTAILLÉ DE MODES DE RÉALISATION PARTICULIERS

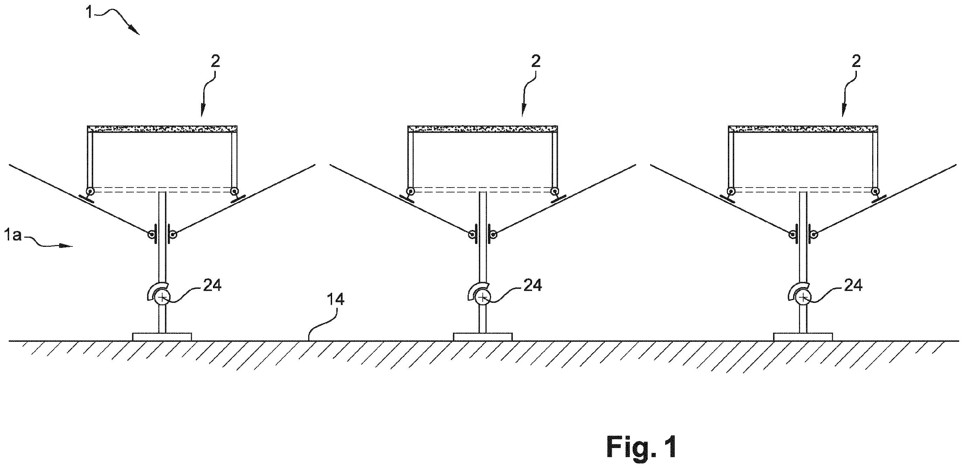

En référence tout d'abord à la figure 1, il est représenté une centrale solaire 1 présentant une pluralité de rangées la, dont seule une partie de l'une de ces rangées est visible sur la figure. De préférence, ces rangées sont parallèles entre elles et comportent chacune plusieurs systèmes d'énergie solaire photovoltaïque 2, agencés côte-à-côte.

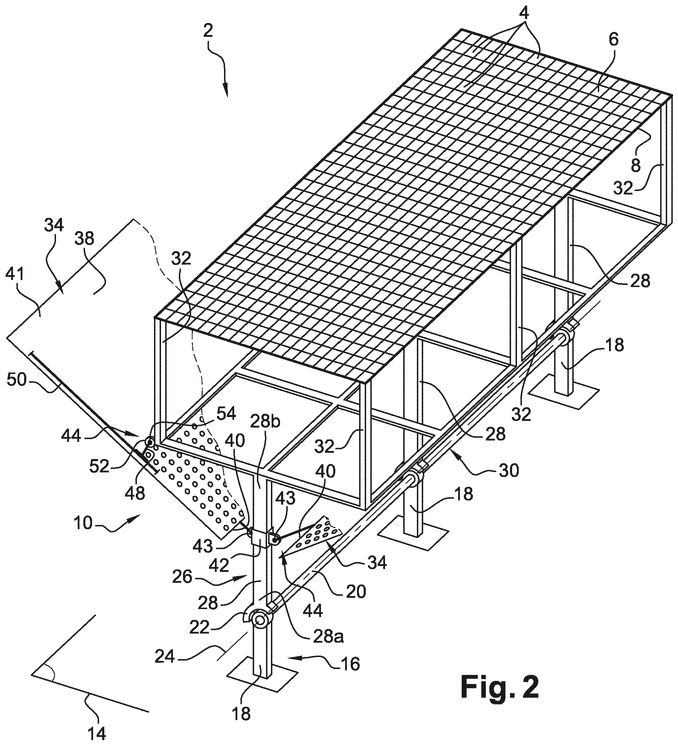

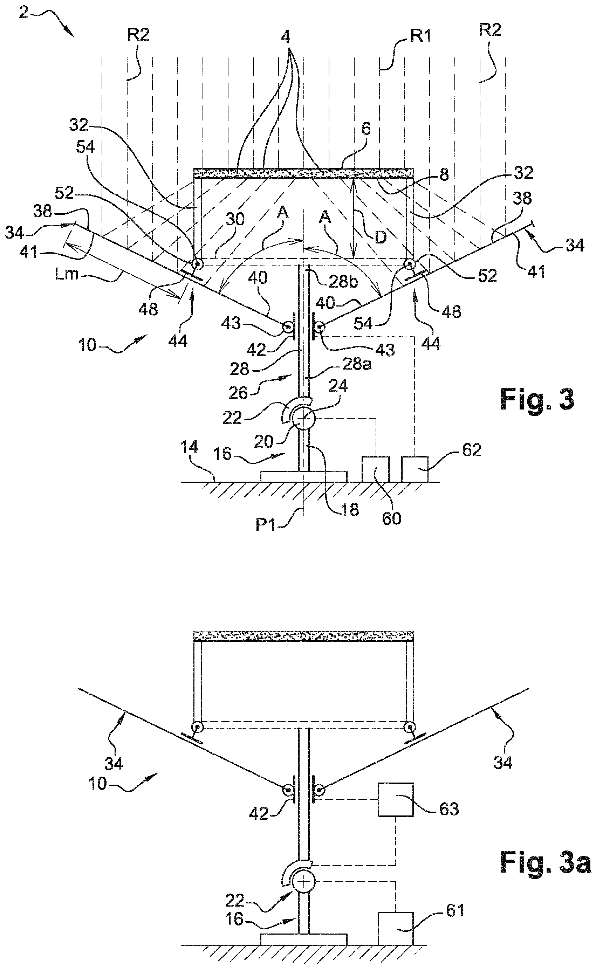

En référence aux figures 2 et 3, il est représenté l'un de ces systèmes 2, selon un mode de réalisation préféré de l'invention. A cet égard, il est noté que tous les systèmes de la centrale solaire sont identiques ou similaires. Ces systèmes sont fixés au sol 14, chacun à l'aide d'une structure de base 16 qui sera décrite ultérieurement. Dans d'autres applications, un ou plusieurs systèmes peuvent être utilisés afin d'être agencés sur une toiture d'un bâtiment.

Dans le mode de réalisation des figures 2 et 3, le système 2 comporte tout d'abord une pluralité de cellules solaires 4. Ces cellules solaires photovoltaïques sont de nature bifaciale, de manière à définir ensemble deux surfaces d'absorption opposées. Dans ce mode de réalisation préféré, il s'agit en face avant d'une surface d'absorption directe 6, et en face arrière, d'une surface d'absorption indirecte 8. Ces deux surfaces 6, 8 sont conventionnellement sensiblement planes et parallèles entre elles, même si une autre réalisation pourrait être envisagée en prévoyant que ces deux surfaces ne soient pas parallèles entre elles. Les cellules solaires 4 peuvent être regroupées par panneaux, préférentiellement tous agencés sensiblement dans un même plan.

L'ensemble de cellules 4 fait partie intégrante d'une unité rotative 10, également connue sous la dénomination anglaise « *tracker* ». D'autres composants équipent cette unité rotative 10, et seront décrits ultérieurement. L'unité rotative 10 demeure ainsi reliée au sol 14 à l'aide d'une structure de base 16, réalisée à l'aide de plusieurs montants 18 supportant une poutre 20. La poutre 20 est préférentiellement de section circulaire, de manière à pouvoir implanter une liaison de rotation 22 entre cette poutre 20 et l'unité rotative. La liaison de rotation 22 définit un axe de pivotement 24 de l'unité 10, cet axe 24 étant préférentiellement celui de la poutre 20. A cet égard, il est noté que la liaison de rotation 22 confère à l'unité 10 la capacité de pivoter relativement à la structure de base 16, afin d'être alignée avec le soleil tout au long de la journée. Ainsi, l'axe de pivotement 24 s'avère orienté et incliné en fonction de la latitude de la localisation des systèmes 2. Par exemple, pour une latitude de 45,6°N, l'axe de pivotement 24 peut être orienté Nord-Sud, et incliné vers le sud d'un angle d'environ 30° par rapport à l'horizontale. Cet angle est figé, ou bien dans une autre réalisation il peut être commandé afin de suivre constamment, ou à intervalles de temps définis, l'évolution de la position du soleil dans le ciel au cours de l'année. Au sein d'une même rangée la de la centrale, les systèmes 2 présentent des axes de pivotement 24 qui sont préférentiellement parallèles entre eux.

L'unité rotative 10 comporte également un châssis de support 26 destiné à supporter les panneaux de cellules 4. Ce châssis 26 comprend tout d'abord un ou plusieurs bras de déport 28, agencés de préférence orthogonalement à l'ensemble de cellules 4. Ces bras 28 sont espacés les uns des autres le long du système 2, en s'inscrivant par exemple dans un même plan vertical que les montants 18, lorsque l'unité 10 adopte sa position médiane verticale telle que représentée sur les figures 2 et 3. Ici, chaque bras 28 est prévu pour déporter verticalement les cellules 4 par rapport à la structure de base 16. Une extrémité basse 28a de chaque bras 28 est raccordée à la liaison de rotation 22, même si alternativement, il peut être prévu une pluralité de liaisons rotatives 22 distinctes et coaxiales, chacune associée à l'extrémité basse 28a d'un bras 28.

L'extrémité haute 28b de chaque bras supporte un cadre 30 du châssis 26. Ce cadre 30, parallèle à l'ensemble de cellules 4 et s'étendant sur une surface analogue, est ajourée au maximum pour permettre le passage de rayons réfléchis sur le sol en direction de la surface d'absorption indirecte 8, comme cela sera détaillé ci-après. Il est formé de manière classique par des montants et des traverses, et il porte à sa périphérie une pluralité d'armatures 32 reliant ce cadre à l'ensemble de cellules 4. Ces armatures 32 permettent un déport supplémentaire des cellules 4 par rapport à la structure de base 16.

Enfin, l'unité rotative 10 comporte deux miroirs 34, qui, dans ce mode de réalisation préféré, présente tous les deux un caractère mobile au sein de l'unité. Toutefois, un seul de ces deux miroirs pourrait être mobile et l'autre fixe, sans sortir du cadre de l'invention.

Les deux miroirs mobiles 34 sont sensiblement plans, et agencés de manière à être déplacés de façon symétrique par rapport à un plan médian P1 de l'unité, dans lequel s'inscrivent les bras de déport 28. Les deux miroirs mobiles 34, agencés respectivement de part et d'autre des bras 28, sont tels que le cadre 30 est interposé verticalement entre ces miroirs et les cellules 4. Ensemble, ils forment un V dont l'ouverture est commandée, comme cela sera détaillé ci-après. Les deux surfaces à l'intérieur du V sont des surfaces de réflexion 38 configurées pour réfléchir la lumière en direction de la surface d'absorption indirecte 8 des cellules 4, comme schématisé par les rayons lumineux R2 sur la figure 3. Ces rayons réfléchis R2 contrastent avec les rayons R1 qui impactent directement la surface d'absorption directe 6 des cellules, orthogonalement à celle-ci en vue de face.

Les miroirs mobiles 34 peuvent être réalisés par des réflecteurs, par exemple utilisés dans le domaine de la photographie, plutôt que par des miroirs plus couteux utilisés dans le domaine du CPV (photovoltaïque à concentration). Le coefficient de réflectance peut s'inscrire dans une gamme de 88-90%. A titre d'exemple, il peut être utilisé une plaque d'aluminium, de l'ordre de 1 mm d'épaisseur, ou encore une plaque de verre sur laquelle est réalisé un dépôt d'aluminium. Selon une possibilité, il peut être utilisé une toile réfléchissante, par exemple une feuille de polymère du type PVF, PVDF, PET, etc., en utilisant un cadre avec des tendeurs afin de maintenir la planéité de la surface de réflexion 38.

Chaque miroir mobile 34 présente une première extrémité 40 sous forme de chant parallèle à l'axe de pivotement 24, et qui est montée pivotante selon un axe 43 sur au moins un moyen 42 coulissant le long d'un bras de déport 28. De préférence, un moyen coulissant 42 peut être prévu sur plusieurs des bras 28, voire sur la totalité d'entre eux. Dans ce cas, le chant 40 qui forme la première extrémité du miroir 34 est monté pivotant sur chacun de ces moyens coulissants 42, éventuellement à l'aide de pattes issues de ce chant 40 et formant partie intégrante d'une liaison pivot d'axe 43. De plus, il est ici préférentiellement fait en sorte qu'au niveau de chaque bras de déport 28 concerné, le moyen coulissant 42 soit commun aux deux miroirs 34, chacun monté pivotant sur ce moyen 42.

La première extrémité 40 de chaque miroir 34 correspond à son chant le plus intérieur au sein de l'unité rotative 10, et s'avère donc opposée à une seconde extrémité libre 41 correspondant à un chant parallèle extérieur. Entre ces deux extrémités 40, 41 de chaque miroir 34, celui-ci est relié à la périphérie du cadre 30 par un dispositif de liaison 44 dont la conception permet au miroir de faire varier son inclinaison, lorsque sa première extrémité est déplacée le long des bras de déport 28. Plus précisément, le dispositif de liaison 44 comprend un organe 48 coulissant le long de la surface de réflexion 38 du miroir mobile 34, par exemple dans un rail 50 schématisé sur la figure 2. Le dispositif 44 comporte également un organe de pivotement 52 permettant une rotation de l'organe coulissant 48 relativement au cadre 30, selon un axe de rotation 54 parallèle aux axes 24, 43 précités. Il est noté que plusieurs dispositifs de liaison 44 peuvent être associés à chaque miroir mobile 34, par exemple en étant répartis le long de la périphérie du cadre 30, et en présentant des axes de rotation 54 confondus.

Lorsque l'unité 10 adopte sa position médiane verticale telle que représentée sur les figures 2 et 3, le moyen coulissant 42 se trouve en position haute sur le bras de déport vertical 28. En vue de face montrée sur ces figures, le bras 28 est orienté verticalement par rapport au sol 16, tandis que l'ensemble de cellules 4 est orienté horizontalement. Cette position est adoptée lorsque le soleil se trouve au plus haut dans le ciel, au cours de la journée. Elle place les deux miroirs mobiles 34 dans une configuration d'envergure maximale, dans laquelle un angle aigu d'inclinaison A entre la surface de réflexion 38 et le plan P1 est préférentiellement compris entre 65 et 80°, et encore plus préférentiellement entre 70 et 75°. Dans cette configuration d'envergure maximale, la seconde extrémité 41 de chaque miroir se trouve éloignée du bras de déport 28. Chacune des deux surfaces de réflexion 38 réfléchit les rayons lumineux R2 sur une moitié de la surface d'absorption indirecte 8 avec la même incidence, impliquant que cette surface 8 est illuminée de manière uniforme sur toute sa superficie. Cela garantit de meilleures performances énergétiques.

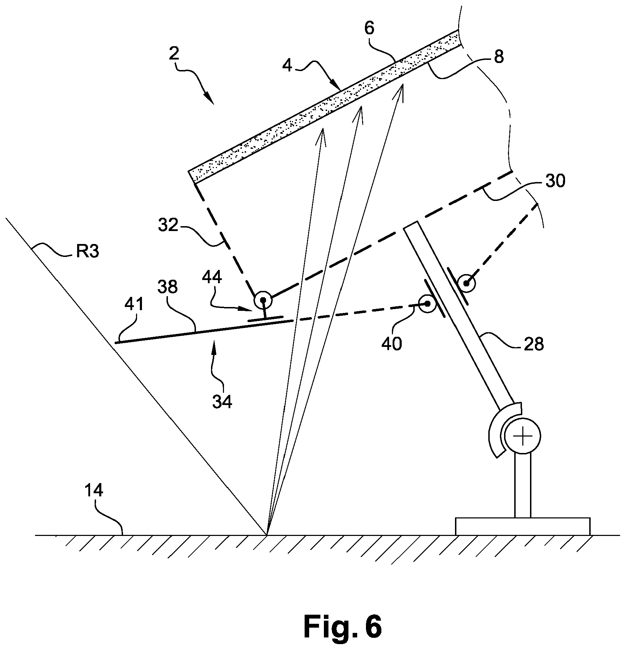

Cette configuration d'envergure maximale définit une largeur active maximale « Lm » de chaque miroir, cette largeur correspondant à la partie du miroir en saillie latéralement du cadre 30. En revanche, l'autre partie du miroir située entre le dispositif de liaison 44 et la première extrémité 40 reste inactive, et peut éventuellement être non-réfléchissante. Cependant, la partie inactive est préférentiellement ajourée de manière à laisser passer des rayons lumineux R3 référencés sur la figure 6, afin que ces derniers se réfléchissant sur le sol 14 puissent effectivement traverser le miroir 34 puis le cadre 30, avant d'impacter la surface d'absorption indirecte 8. Ce rayonnement est d'autant plus important que le sol 14 présente un pouvoir réfléchissant, le sol étant alors par exemple formé à l'aide de graviers blancs. Ce rayonnement provenant des rayons R3 s'ajoute au rayonnement provenant des rayons R2, montrés sur la figure 2 et qui se réfléchissent sur la surface 38 des miroirs.

Sur cette même figure, il est référencé plusieurs dimensions du système, parmi lesquelles la largeur active maximale « Lm » de chaque miroir, préférentiellement comprise entre 2 et 4,5 m. En outre, la distance d'écartement « D » entre le cadre 30 et la surface d'absorption indirecte 8 des cellules 4 est comprise entre 1 et 3 m.

Le système 2 comporte également des moyens pour mettre en rotation l'unité 10, et pour faire varier l'amplitude des miroirs 34. Pour ce faire, dans le mode de réalisation décrit, il est prévu un premier actionneur ou un premier groupe d'actionneurs 60, permettant de commander la liaison de rotation 22 entre l'unité 10 et la structure de base 16. L'amplitude de rotation permise par ces premiers actionneurs 60, de part et d'autre de la position médiane verticale de la figure 2, peut être comprise entre 30 et 70°. Etant donné que le facteur de concentration est faible, la précision d'orientation de l'unité 10 peut être relativement grossière (± 3° au lieu de ±1° pour les CPV). Il apparait donc possible d'utiliser des actionneurs simples et robustes. Il n'est ainsi pas nécessaire de prévoir une détection de position magnétique, ce qui autorise par exemple la simple mise en série d'actionneurs « tout ou rien », type aimants ou vérins.

Le système 2 comporte également un second actionneur ou un second groupe d'actionneurs 62, permettant de commander l'ouverture / l'amplitude des miroirs mobiles 34. Les actionneurs 62 permettent de déplacer chaque moyen coulissant 42 de bas en haut et de haut à bas, le long du bras associé 28. Il peut par exemple s'agir d'un moteur linéaire, ou bien d'un simple vérin.

Dans ce mode de réalisation préféré, les premiers actionneurs 60 sont distincts des seconds actionneurs 62. Cependant, comme l'ouverture des miroirs 34 est directement corrélée à l'inclinaison de l'unité rotative autour de l'axe de pivotement 24, ces actionneurs 60, 62 sont synchronisés.

Selon une alternative de réalisation montrée sur la figure 3a, il est prévu un actionneur ou un groupe d'actionneurs communs 61 qui commande directement la liaison de rotation 22, entre l'unité 10 et la structure de base 16. Ces actionneurs commandent simultanément l'ouverture des miroirs mobiles 34, par le biais d'un dispositif de transmission de mouvement 63 agencé entre la liaison de rotation 22 et le moyen coulissant 42. Ce dispositif de transmission 63 est de préférence un dispositif mécanique, comprenant des organes de transmission classiques comme des cames, bielles, vis sans fin, etc.

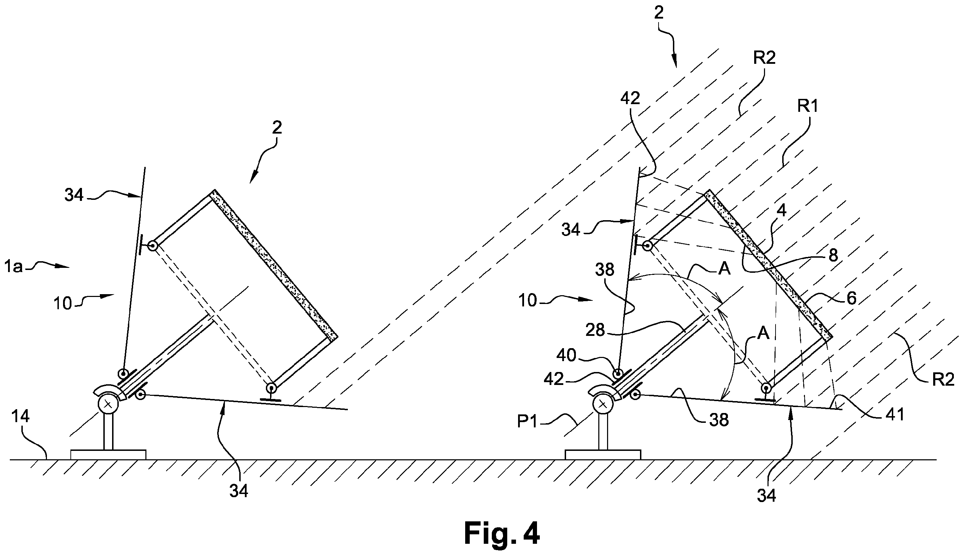

La figure 4 montre deux systèmes 2 directement consécutifs au sein de la même rangée, avec leurs unités rotatives 10 en position extrême de matinée, c'est-à-dire avec la surface d'absorption directe 6 orientée vers l'est. Dans cette position, l'inclinaison de l'unité 10 est maximale du côté d'un premier des deux miroirs 34, à savoir celui de droite sur la figure 4. La centrale est de préférence commandée de sorte que tous les systèmes 2 ont leurs unités 10 présentant la même inclinaison à chaque instant de la journée.

Puisque cette position est adoptée en matinée lorsque le soleil est rasant, les deux miroirs 34 adoptent alors une position d'envergure minimale, dans laquelle l'angle aigu d'inclinaison A entre la surface de réflexion 38 et le plan P1 est préférentiellement compris entre 5 et 30°, même si une valeur supérieure peut être retenue. Dans cette configuration, la seconde extrémité 41 des deux miroirs 34 est plus proche du bras 28 et du plan P1 que dans la configuration d'ouverture maximale.

De plus, dans cette configuration d'envergure minimale, chaque miroir 34 est abaissé en raison du déplacement de sa première extrémité 40 vers le bas du bras de déport 28, via le moyen de coulissement 42 amené en position basse par les seconds actionneurs. De ce fait, l'ombrage induit par le second miroir 34, le plus à gauche sur la figure 4, se révèle particulièrement faible, et autorise surtout un fort rapprochement du système 2 directement consécutif, tout en garantissant que ce dernier ait ses miroirs 34 intégralement éclairés par le soleil.

Dans cette configuration, chacune des deux surfaces de réflexion 38 réfléchit les rayons lumineux R2 sur l'autre des deux surfaces 38, avant que ces rayons n'impactent une moitié de la surface d'absorption indirecte 8 avec la même incidence. Dans certains cas, la faible ouverture des miroirs pourrait ne pas permettre l'illumination de toute la surface 8 à l'aide des rayons réfléchis R2. Dans ce cas de figure, l'illumination de la surface d'absorption indirecte 8 serait de toute façon complétée par les rayons lumineux R3, décrits précédemment en référence à la figure 6.

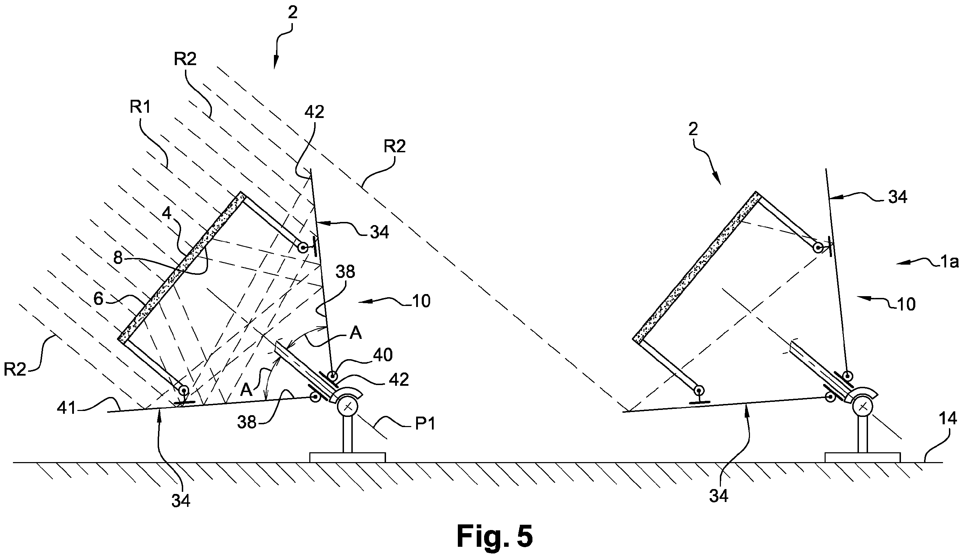

Ainsi, durant la journée, les systèmes 2 de chaque rangée la sont commandés par les premiers actionneurs de façon à ce que leurs unités rotatives 10 soient chacune pivotée de la position extrême de matinée de la figure 4, à une position extrême de soirée montrée la figure 5, symétrique à la précédente. Dans cette position extrême de soirée, l'unité rotative 10 est effectivement inclinée du côté du second miroir 34, avec ses deux miroirs à nouveau en configuration d'envergure minimale. De ce fait, l'ombrage induit par le premier miroir 34, le plus à droite sur la figure 5, se révèle particulièrement faible, et autorise surtout un fort rapprochement du système 2 directement consécutif, tout en garantissant que ce dernier ait ses miroirs 34 intégralement éclairés par le soleil.

Durant ce déplacement entre les deux positions extrêmes précitées, l'unité rotative 10 transite par la position médiane verticale de la figure 3. Ce déplacement journalier s'accompagne d'une commande de l'ouverture des miroirs 34. En particulier, il est prévu que chacun des deux miroirs mobiles 34 soit déplacé de sa configuration d'envergure minimale vers sa configuration d'ouverture maximale, lorsque l'unité rotative 10 est déplacée de la position extrême de matinée vers sa position médiane verticale. Ensuite, il est prévu que chacun des deux miroirs 34 soit déplacé de sa configuration d'envergure maximale vers sa configuration d'ouverture minimale, lorsque l'unité rotative est déplacée de sa position médiane verticale vers la position extrême de soirée. Le déplacement des miroirs, via les seconds actionneurs, peut s'effectuer de manière linéaire, ou bien par palier à intervalles de temps réguliers.

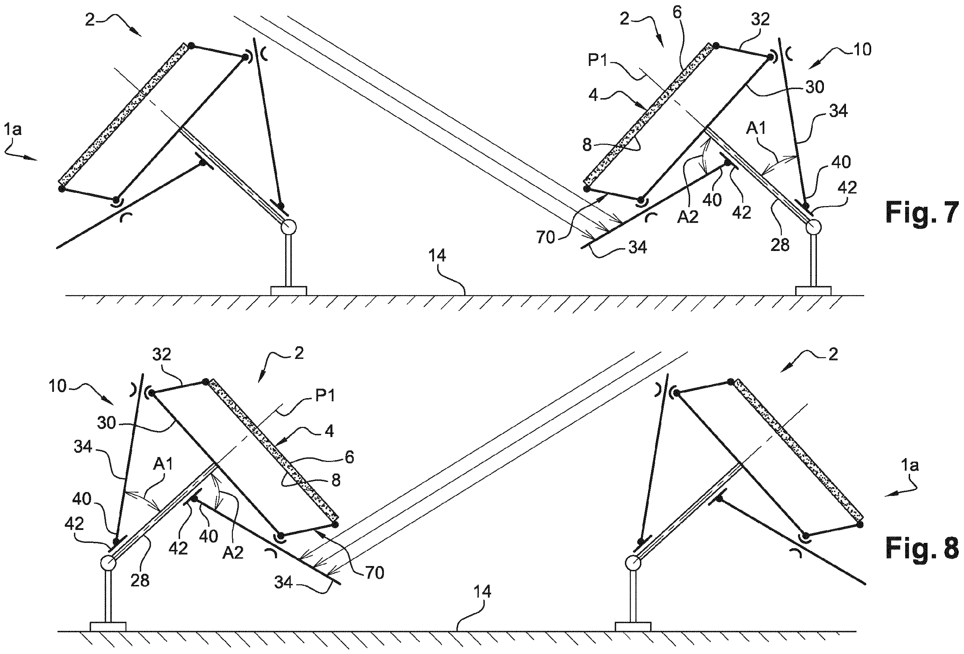

Selon un autre mode de réalisation montré sur les figures 7 et 8, les deux miroirs 34 ne sont plus commandés de façon à être déplacés symétriquement par rapport au plan P1 traversant les bras de déport 28, mais ils sont à l'inverse déplacés de manière dissymétrique. La première extrémité 40 de chacun d'eux est montée sur son propre moyen 42 coulissant le long du bras 28, de sorte que les deux moyens 42 ne sont pas nécessairement au même niveau sur ce bras. C'est notamment le cas en position extrême de soirée montrée sur la figure 7, dans laquelle le premier miroir 34, toujours à droite sur la figure, réside en configuration d'envergure minimale afin de limiter l'ombrage sur les miroirs du système 2 directement consécutif. A l'inverse, le second miroir 34 adopte une configuration d'envergure plus élevée, voire maximale, permettant une meilleure illumination de la surface d'absorption indirecte 8 des cellules 4, sans être problématique vis-à-vis de l'ombrage généré sur le système directement consécutif. Les deux angles aigus d'inclinaison A1 et A2, respectivement associés aux deux miroirs 34, présentent ainsi des valeurs différentes en position extrême de soirée.

Une situation analogue est retenue en position extrême de matinée montrée sur la figure 8, dans laquelle le second miroir 34, toujours à gauche sur la figure, réside en configuration d'envergure minimale afin de limiter l'ombrage sur les miroirs du système 2 directement consécutif. A l'inverse, le premier miroir 34 adopte quant à lui une configuration d'envergure plus élevée, voire maximale, permettant une meilleure illumination de la surface d'absorption indirecte 8 des cellules 4, sans être problématique vis-à-vis de l'ombrage généré sur le système directement consécutif.

Au cours de la rotation journalière de l'unité 10, la commande de déplacement des deux miroirs 34 est adaptée de manière à obtenir les ouvertures montrées pour les positions extrêmes sur les figures 7 et 8, tout en faisant en sorte qu'ils adoptent tous les deux la configuration d'envergure maximale lorsque l'unité 10 se trouve en position médiane verticale de milieu de journée. Ici encore, un déplacement linéaire ou par palier peut être adopté pour la mise en mouvement des deux miroirs.

Enfin, il est noté que dans ce mode de réalisation préféré, ou dans le précédent, l'ensemble de cellules 4 est également prévu pour être déplacé latéralement du côté du premier miroir, ainsi que du côté du second miroir. Plus précisément, en position extrême de soirée, l'ensemble de cellules 4 n'est plus symétrique par rapport au plan P1, mais décalé transversalement vers le côté du second miroir afin de limiter l'ombrage induit sur le système 2 directement consécutif. A l'inverse, en position extrême de matinée, l'ensemble de cellules 4 n'est plus symétrique par rapport au plan P1, mais décalé transversalement vers le côté du premier miroir afin de limiter l'ombrage induit sur le système 2 directement consécutif. En d'autres termes, au cours de la rotation journalière de l'unité 10, une commande additionnelle permet de mettre en mouvement l'ensemble de cellules 4 de manière à ce qu'il se déplace d'une position extrême de côté montrée sur la figure 8, vers une position extrême de côté opposé montrée sur la figure 7, tout en faisant en sorte qu'il adopte une position centrale de symétrie par rapport au plan P1 lorsque l'unité réside en position médiane verticale de milieu de journée.

Pour permettre ce déplacement de l'ensemble de cellules 4, une simple liaison de translation est possible, mais il est préféré la mise en œuvre d'un dispositif 70 à parallélogramme déformable. Le cadre 30 et l'ensemble de cellules 4 constituent alors deux côtés opposés du parallélogramme, tandis que les armatures 32 remplissent la fonction des deux autres côtés opposés de ce parallélogramme. Pour l'actionnement, un ou plusieurs autres actionneurs sont mis en œuvre, ou bien un dispositif de transmission de mouvement spécifique est retenu, commandé par un ou plusieurs autres actionneurs du système 2.

Bien entendu, diverses modifications peuvent être apportées par l'homme du métier à l'invention qui vient d'être décrite, uniquement à titre d'exemples non limitatifs. En particulier, les caractéristiques des différents modes de réalisation sont combinables entre elles. En outre, il est noté que la disposition du plan des cellules par rapport au châssis n'est pas limitée à celle des exemples décrits précédemment, mais cette disposition relative peut être quelconque. Le plan des cellules pourrait ainsi être incliné d'un angle différent de 90° par rapport au plan des bras de déport 28. Cet angle pourrait même être nul, conduisant à un parallélisme ou à une identité entre le plan des cellules 4 et celui des bras 28. Dans ce dernier cas, seule l'une des deux surfaces de réflexion 38 des deux miroirs 34 est prévue pour réfléchir la lumière en direction de la surface d'absorption indirecte 8 des cellules 4, l'autre surface 38 étant configurée pour réfléchir la lumière en direction de la surface d'absorption directe 6.

## Revendications

1. Système d'énergie solaire photovoltaïque (2) comportant :
- une structure de base (16) ;
- une unité rotative (10) ;
- une liaison de rotation (22) entre l'unité rotative (10) et la structure de base (16), la liaison de rotation définissant un axe de pivotement (24) de l'unité rotative,
l'unité rotative (10) comprenant :
- un ensemble de cellules solaires photovoltaïques bifaciales (4), définissant conjointement deux surfaces opposées destinées à absorber une énergie de rayonnement solaire ;
- un châssis (26) de support desdites cellules, le châssis comprenant au moins un bras (28) de déport des cellules (4) par rapport à la structure de base (16), une extrémité basse du bras de déport (28) étant raccordée à la liaison de rotation (22) ;
- deux miroirs (34) définissant chacun une surface de réflexion (38) configurée pour réfléchir la lumière en direction de l'ensemble de cellules (4), de préférence en direction d'une surface d'absorption indirecte (8) de cet ensemble, les deux miroirs étant disposés respectivement de part et d'autre du bras de déport (28),
**caractérisé en ce qu'**au moins l'un des deux miroirs (34) est mobile en présentant une première extrémité (40) montée pivotante sur un moyen (42) coulissant le long du bras de déport (28), le moyen coulissant (42) étant déplaçable entre une position haute amenant le miroir mobile (34) dans une configuration d'envergure maximale, et une position basse amenant le miroir mobile (34) dans une configuration d'envergure minimale dans laquelle une seconde extrémité (41) du miroir mobile, opposée à la première extrémité, se situe plus proche du bras de déport (28) que dans la configuration d'envergure maximale.

2. Système selon la revendication 1, **caractérisé en ce que** le châssis de support (26) comporte également un cadre (30) fixé sur une extrémité haute du bras de déport (28), et **en ce qu'**un dispositif de liaison (44) est prévu entre chaque miroir mobile (34) et le cadre (30) du châssis de support, ce dispositif de liaison (44) comprenant un organe (48) coulissant le long du miroir mobile, ainsi qu'un organe de pivotement (52) permettant une rotation de l'organe coulissant (48) relativement au cadre (30).

3. Système selon la revendication 2, **caractérisé en ce que** le cadre (30) est sensiblement parallèle à l'ensemble de cellules solaires photovoltaïques bifaciales (4), le cadre étant interposé entre les deux miroirs (34) et l'ensemble de cellules.

4. Système selon la revendication 2 ou la revendication 3, **caractérisé en ce que** le châssis de support (26) comporte également une pluralité d'armatures (32) reliant le cadre (30) à l'ensemble de cellules solaires photovoltaïques bifaciales (4).

5. Système selon l'une quelconque des revendications précédentes, **caractérisé en ce que** le miroir mobile (34) définit un angle aigu d'inclinaison de miroir (A) avec un plan (P1) orthogonal à l'ensemble de cellules solaires photovoltaïques bifaciales (4), l'angle aigu d'inclinaison de miroir (A) étant compris entre 5 et 30° dans la configuration d'envergure minimale, et compris entre 65 et 80° dans la configuration d'envergure maximale.

6. Système selon l'une quelconque des revendications précédentes, **caractérisé en ce que** les deux miroirs (34) sont mobiles, et agencés de manière à être déplacés de façon symétrique ou dissymétrique.

7. Système selon la revendication 6, **caractérisé en ce que** les deux miroirs mobiles (34) sont agencés de manière à être déplacés de façon symétrique, la première extrémité (40) de chacun d'eux étant montée pivotante sur un même moyen (42) coulissant le long du bras de déport (28).

8. Système selon la revendication 6, **caractérisé en ce que** les deux miroirs mobiles (34) sont agencés de manière à être déplacés de façon dissymétrique, la première extrémité (40) de chacun d'eux étant montée pivotante respectivement sur deux moyens distincts (42) coulissant le long du bras de déport (28).

9. Système selon l'une quelconque des revendications précédentes, **caractérisé en ce que** l'ensemble de cellules solaires photovoltaïques bifaciales (4) est configuré pour être déplacé latéralement du côté de l'un des deux miroirs, et du côté de l'autre miroir.

10. Système selon la revendication 9, **caractérisé en ce que** le châssis de support (26) comporte un dispositif à parallélogramme déformable (70) conçu pour déplacer latéralement l'ensemble de cellules solaires photovoltaïques bifaciales (4).

11. Système selon l'une quelconque des revendications précédentes, **caractérisé en ce qu'**il comporte également au moins un premier actionneur (60) de la liaison de rotation (22) entre l'unité rotative (10) et la structure de base (16), ainsi qu'au moins un second actionneur (62) de miroir mobile, le/les premiers actionneurs étant distincts du/des seconds actionneurs.

12. Système selon l'une quelconque des revendications 1 à 10, **caractérisé en ce qu'**il comporte également un actionneur commun (61) commandant simultanément la liaison de rotation (22) entre l'unité rotative (10) et la structure de base (16), ainsi que chaque miroir mobile (34).

13. Centrale solaire (1) comprenant au moins une rangée (1a) de systèmes d'énergie solaire photovoltaïque (2) selon l'une quelconque des revendications précédentes, les axes de pivotement (24) des unités rotatives (10) appartenant aux systèmes de la rangée considérée, étant parallèles entre eux.

14. Centrale selon la revendication 13, **caractérisée en ce qu'**elle comporte plusieurs rangées (1a) de systèmes d'énergie solaire photovoltaïque (2).

15. Procédé de commande d'une centrale solaire (1) selon la revendication 13 ou la revendication 14, **caractérisée en ce qu'**au cours d'une journée, l'unité rotative (10) des systèmes (2) de chaque rangée est pivotée d'une position extrême de matinée dans laquelle l'unité est inclinée du côté d'un premier des deux miroirs (34), à une position extrême de soirée dans laquelle l'unité rotative (10) est inclinée du côté d'un second des deux miroirs (34), en passant par une position médiane verticale de l'unité rotative, et **en ce que** le procédé est mis en œuvre de manière à ce que pour au moins l'un des systèmes (2) d'au moins l'une des rangées (1a) :
le premier miroir mobile (34) est déplacé de sa configuration d'envergure minimale vers sa configuration d'ouverture maximale lorsque l'unité rotative (10) est déplacée de la position extrême de matinée vers sa position médiane verticale, et/ou **en ce que** le premier miroir mobile (34) est déplacé de sa configuration d'envergure maximale vers sa configuration d'ouverture minimale lorsque l'unité rotative (10) est déplacée de sa position médiane verticale vers la position extrême de soirée ;
et/ou **en ce que**
le second miroir mobile (34) est déplacé de sa configuration d'envergure minimale vers sa configuration d'ouverture maximale lorsque l'unité rotative (10) est déplacée de la position extrême de matinée vers sa position médiane verticale, et/ou **en ce que** le second miroir mobile (34) est déplacé de sa configuration d'envergure maximale vers sa configuration d'ouverture minimale lorsque l'unité rotative (10) est déplacée de sa position médiane verticale vers la position extrême de soirée.

## Patentansprüche

1. Photovoltaisches Solarenergiesystem (2), enthaltend:
- eine Basisstruktur (16);
- eine Dreheinheit (10);
- ein Drehverbindung (22) zwischen der Dreheinheit (10) und der Basisstruktur (16), wobei die Drehverbindung eine Schwenkachse (24) der Dreheinheit definiert,
wobei die Dreheinheit (10) enthält:
- eine Anordnung von zweiseitigen photovoltaischen Solarzellen (4), die gemeinsam zwei entgegengesetzte Oberflächen zur Aufnahme einer Sonnenstrahlungsenergie definieren;
- ein Gestell (26) zum Tragen der Zellen, wobei das Gestell mindestens einen Arm (28) zum Verlagern der Zellen (4) in Bezug auf die Basisstruktur (16) enthält, wobei ein unteres Ende des Verlagerungsarms (28) mit der Drehverbindung (22) verbunden ist;
- zwei Spiegel (34), die jeweils eine Reflexionsfläche (38) definieren, die dazu ausgelegt ist, das Licht in Richtung der Anordnung von Zellen (4) zu reflektieren, vorzugsweise in Richtung einer indirekten Absorptionsfläche (8) dieser Anordnung, wobei die beiden Spiegel jeweils auf der einen bzw. der andere Seite des Verlagerungsarms (28) angeordnet sind,
**dadurch gekennzeichnet, dass**
zumindest einer der beiden Spiegel (34) beweglich ist, indem er ein erstes Ende (40), das verschwenkbar an einer Verschiebeeinrichtung (42) gelagert ist, die entlang des Verlagerungsarms (28) verschiebbar ist, wobei die Verschiebeeinrichtung (42) zwischen einer oberen Position, in welcher der bewegliche Spiegel (34) in einer Stellung maximaler Spannweite gebracht ist, und einer unteren Position verschiebbar ist, in welcher der bewegliche Spiegel (34) in einer Stellung minimaler Spannweite gebracht ist, in welcher ein dem ersten Ende entgegengesetztes zweites Ende (41) des beweglichen Spiegels näher bei dem Verlagerungsarm (28) liegt als in der Stellung maximaler Spannweite.

2. System nach Anspruch 1,
**dadurch gekennzeichnet, dass**
das Traggestell (26) auch einen Rahmen (30) enthält, der an ein oberes Ende des Verlagerungsarms (28) befestigt ist,
und dass eine Verbindungsvorrichtung (44) zwischen jedem beweglichen Spiegel (34) und dem Rahmen (30) des Traggestells vorgesehen ist, wobei diese Verbindungsvorrichtung (44) ein Element (48), das entlang des beweglichen Spiegels verschiebbar ist, sowie ein Schwenkelement (52) enthält, das eine Drehung des Verschiebeelements (48) relativ zum Rahmen (30) ermöglicht.

3. System nach Anspruch 2,
**dadurch gekennzeichnet, dass**
der Rahmen (30) im Wesentlichen parallel zur Anordnung von zweiseitigen photovoltaischen Solarzellen (4) verläuft, wobei der Rahmen zwischen den beiden Spiegeln (34) und der Zellenanordnung angeordnet ist.

4. System nach Anspruch 2 oder Anspruch 3,
**dadurch gekennzeichnet, dass**
das Traggestell (26) auch eine Vielzahl von Armierungen (32) umfasst, die den Rahmen (30) mit der Anordnung von zweiseitigen photovoltaischen Solarzellen (4) verbinden.

5. System nach einem der vorstehenden Ansprüche,
**dadurch gekennzeichnet, dass**
der bewegliche Spiegel (34) einen spitzen Spiegelneigungswinkel (A) mit einer Ebene (P1) definiert, die orthogonal zu der Anordnung von zweiseitigen photovoltaischen Solarzellen (4) verläuft, wobei der spitze Spiegelneigungswinkel (A) zwischen 5 und 30° in der Stellung minimaler Spannweite und zwischen 65 und 80° in der Stellung maximaler Spannweite liegt.

6. System nach einem der vorstehenden Ansprüche,
**dadurch gekennzeichnet, dass**
beide Spiegel (34) beweglich und so angeordnet sind, dass sie symmetrisch oder asymmetrisch bewegt werden können.

7. System nach Anspruch 6,
**dadurch gekennzeichnet, dass**
die beiden beweglichen Spiegel (34) so angeordnet sind, dass sie symmetrisch bewegt werden können, wobei jeweils ihr erstes Ende (40) schwenkbar an der gleichen Verschiebeeinrichtung (42) gelagert ist, die entlang des Verlagerungsarms (28) verschiebbar ist.

8. System nach Anspruch 6,
**dadurch gekennzeichnet, dass**
die beiden beweglichen Spiegel (34) so angeordnet sind, dass sie asymmetrisch bewegt werden können, wobei jeweils ihr erstes Ende (40) schwenkbar an zwei getrennten Verschiebeeinrichtungen (42) gelagert ist, die entlang des Verlagerungsarms (28) verschiebbar sind.

9. System nach einem der vorstehenden Ansprüche,
**dadurch gekennzeichnet, dass**
die Anordnung von zweiseitigen photovoltaischen Solarzellen (4) dazu ausgelegt ist, seitlich auf die Seite eines der beiden Spiegel und auf die Seite des anderen Spiegels bewegt zu werden.

10. System nach Anspruch 9,
**dadurch gekennzeichnet, dass**
das Traggestell (26) eine verformbare Parallelogrammvorrichtung (70) enthält, die dazu ausgelegt ist, die Anordnung von zweiseitigen photovoltaischen Solarzellen (4) seitlich zu verlagern.

11. System nach einem der vorstehenden Ansprüche,
**dadurch gekennzeichnet, dass**
es ferner mindestens ein erstes Betätigungsglied (60) für die Drehverbindung (22) zwischen der Dreheinheit (10) und der Basisstruktur (16) sowie mindestens ein zweites Betätigungsglied (62) für den beweglichen Spiegel enthält, wobei das bzw. die ersten Betätigungsglieder von dem bzw. den zweiten Betätigungsgliedern verschieden ist bzw. sind.

12. System nach einem der Ansprüche 1 bis 10,
**dadurch gekennzeichnet, dass**
es ferner ein gemeinsames Betätigungsglied (61) enthält, das gleichzeitig die Drehverbindung (22) zwischen der Dreheinheit (10) und der Basisstruktur (16) sowie jeden beweglichen Spiegel (34) steuert.

13. Solarkraftwerk (1) mit mindestens einer Reihe (1a) von photovoltaischen Solarenergiesystemen (2) nach einem der vorstehenden Ansprüche,
wobei die Schwenkachsen (24) der Dreheinheiten (10), die zu den Systemen der betreffenden Reihe gehören, parallel zueinander verlaufen.

14. Kraftwerk nach Anspruch 13,
**dadurch gekennzeichnet, dass**
es mehrere Reihen (1a) von photovoltaischen Solarenergiesystemen (2) enthält.

15. Verfahren zum Steuern eines Solarkraftwerks (1) nach Anspruch 13 oder Anspruch 14,
**dadurch gekennzeichnet, dass**
im Laufe eines Tages die Dreheinheit (10) der Systeme (2) einer jeden Reihe von einer Morgen-Endposition, in der die Einheit zur Seite eines ersten der beiden Spiegel (34) geneigt ist, in eine Abend-Endposition, in der die Dreheinheit (10) zur Seite eines zweiten der beiden Spiegel (34) geneigt ist, verschwenkt wird und dabei durch eine vertikale Mittelposition der Dreheinheit verläuft, und dass das Verfahren so durchgeführt wird, dass für mindestens eines der Systeme (2) mindestens einer der Reihen (1a):
der erste bewegliche Spiegel (34) von seiner Stellung minimaler Spannweite in seine Stellung maximaler Öffnung bewegt wird, wenn die Dreheinheit (10) von der Morgen-Endposition in ihre vertikale Mittelposition bewegt wird, und/oder dass der erste bewegliche Spiegel (34) von seiner Stellung maximaler Spannweite in seine Stellung minimaler Öffnung bewegt wird, wenn die Dreheinheit (10) von ihrer vertikalen Mittelposition in die Abend-Endposition bewegt wird;
und/oder
der zweite bewegliche Spiegel (34) von seiner Stellung minimaler Spannweite in seine Stellung maximaler Öffnung bewegt wird, wenn die Dreheinheit (10) von der Morgen-Endposition in ihre vertikale Mittelposition bewegt wird, und/oder der zweite bewegliche Spiegel (34) von seiner Stellung maximaler Spannweite in seine Stellung minimaler Öffnung bewegt wird, wenn die Dreheinheit (10) von ihrer vertikalen Mittelposition in die Abend-Endposition bewegt wird.

## Claims

1. Photovoltaic solar energy system (2) comprising:
- a base structure (16);
- a rotating unit (10);
- a rotation connection (22) between the rotating unit (10) and the base structure (16), the rotation connection defining a pivot axis (24) of the rotating unit,
the rotating unit (10) comprising:
- a set of bifacial photovoltaic solar cells (4), jointly defining two opposite surfaces intended to absorb energy from solar radiation;
- a support frame (26) of said cells, the frame comprising at least one arm (28) for offsetting cells (4) with respect to the base structure (16), a low end of the offsetting arm (28) being connected to the rotation connection (22);
- two mirrors (34) each defining a reflector surface (38) configured to reflect the light in the direction of the set of cells (4), preferably in the direction of an indirect absorption surface (8) of this set, the two mirrors being arranged respectively on either side of the offsetting arm (28),
**characterised in that** at least one of the two mirrors (34) is mobile by having a first end (40) pivotably mounted on a means (42) sliding along the offsetting arm (28), the sliding means (42) able to be displaced between a high position bringing the mobile mirror (34) into a configuration of maximum extent, and a low position bringing the mobile mirror (34) into a configuration of minimum extent wherein a second end (41) of the mobile mirror, opposite the first end, is located closer to the offsetting arm (28) than in the configuration of maximum extent.

2. System according to claim 1, **characterised in that** the support frame (26) also comprises a frame (30) fixed on a high end of the offsetting arm (28), and **in that** a connection device (44) is provided between each mobile mirror (34) and the frame (30) of the support frame, this connection device (44) comprising a member (48) sliding along the mobile mirror, as well as a pivot member (52) allowing for a rotation of the sliding member (48) in relation to the frame (30).

3. System according to claim 2, **characterised in that** the frame (30) is substantially parallel to the set of bifacial photovoltaic solar cells (4), the frame being interposed between the two mirrors (34) and the set of cells.

4. System according to claim 2, **characterised in that** the support frame (26) also comprises a plurality of frameworks (32) connecting the frame (30) to the set of bifacial photovoltaic solar cells (4).

5. System according to claim 1, **characterised in that** the mobile mirror (34) defines an acute mirror inclination angle (A) with a plane (P1) orthogonal to the set of bifacial photovoltaic solar cells (4), the acute mirror inclination angle (A) being between 5 and 30° in the configuration of minimum extent, and between 65 and 80° in the configuration of maximum extent.

6. System according to claim 1, **characterised in that** the two mirrors (34) are mobile, and arranged to be displaced symmetrically or asymmetrically.

7. System according to claim 6, **characterised in that** the two mobile mirrors (34) are arranged in such a way as to be displaced symmetrically, the first end (40) of each one of them being pivotably mounted on the same means (42) sliding along the offsetting arm (28).

8. System according to claim 6, **characterised in that** the two mobile mirrors (34) are arranged in such a way as to be displaced asymmetrically, the first end (40) of each one of them being pivotably mounted respectively on two separate means (42) sliding along the offsetting arm (28).

9. System according to claim 1, **characterised in that** the set of bifacial photovoltaic solar cells (4) is configured to be displaced laterally on the side of one of the two mirrors, and on the side of the other mirror.

10. System according to claim 9, **characterised in that** the support frame (26) comprises a device with a deformable parallelogram (70) designed to laterally displace the set of bifacial photovoltaic solar cells (4).

11. System according to claim 1, **characterised in that** it also comprises at least one first actuator (60) of the rotation connection (22) between the rotating unit (10) and the base structure (16), as well as at least one second mobile mirror actuator (62), with the first actuator or actuators being separate from the second actuator or actuators.

12. System according to claim 1, **characterised in that** it also comprises a common actuator (61) that simultaneously controls the rotation connection (22) between the rotating unit (10) and the base structure (16), as well as each mobile mirror (34).

13. Solar power plant (1) comprising at least one row (1a) of photovoltaic solar energy systems (2) according to claim 1, with the pivot axes (24) of the rotating units (10) belonging to the systems of the row considered, being parallel to each other.

14. Power station according to claim 13, **characterised in that** it comprises several rows (1a) of photovoltaic solar energy systems (2).

15. Method for controlling a solar power station (1) according to claim 13, **characterised in that** during the course of a day, the rotating unit (10) of the systems (2) of each row is pivoted from an extreme morning position wherein the unit is inclined on the side of a first of the two mirrors (34), to an extreme evening position wherein the rotating unit (10) is inclined on the side of one second of the two mirrors (34), passing through a vertical median position of the rotating unit, and **in that** the method is implemented in such a way that for at least one of the systems (2) of at least one of the rows (1a):
the first mobile mirror (34) is displaced from its configuration of minimum extent to its configuration of maximum extent when the rotating unit (10) is displaced from the extreme morning position to its vertical median position, and/or **in that** the first mobile mirror (34) is displaced from its configuration of maximum extent to its configuration of minimum extent when the rotating unit (10) is displaced from its vertical median position to the extreme evening position;
and/or **in that**
the second mobile mirror (34) is displaced from its configuration of minimum extent to its configuration of maximum extent when the rotating unit (10) is displaced from the extreme morning position to its vertical median position, and/or **in that** the second mobile mirror (34) is displaced from its configuration of maximum extent to its configuration of minimum extent when the rotating unit (10) is displaced from its vertical median position to the extreme evening position.
